# EUROPEAN PATENT APPLICATION

(11) **EP 4 723 113 A1**
(43) Date of publication of application: **08.04.2026**
(21) Application number: 25197790.6
(22) Date of filing: 25.08.2025
(51) Int. Cl.: G11C 5/04, H10W 90/00

(54) **ASSEMBLY OF MULTI-STACK MEMORY**

(30) Priority: 02.10.2024 US 202463702612 P; 25.10.2024 US 202463711739 P; 23.05.2025 US 202519218091
(71) Applicant: MEDIATEK INC., Hsinchu City 30078 (TW)
(72) Inventor: KUMAR, Arvind, San Jose (US); KUMASHIKAR, Mahesh K., San Jose (US); NALAMALPU, Ankireddy, San Jose (UM)
(74) Representative: Haseltine Lake Kempner LLP

(57) **Abstract**

An integrated circuit includes a host die and a base die, both of which are disposed on an interposer. The host die includes multiple processors, and the base die includes at least two high-bandwidth memory (HBM) stacks that are disposed on the base die and communicate with the host die through the base die and the interposer. The at least two HBM stacks and the host die are arranged in a row with the host die at one end of the row. The base die further includes a controller circuit operative to multiplex outgoing data from the at least two HBM stacks to the host die, and demultiplex incoming data from the host die to the at least two HBM stacks.

## Description

### CROSS-REFERENCE TO RELATED APPLICATIONS

This application claims the benefit of U.S. Provisional Application No. 63/702,612 filed on October 2, 2024, and U.S. Provisional Application No. 63/711,739 filed on October 25, 2024, the entirety of both of which is incorporated by reference herein.

### TECHNICAL FIELD

Embodiments of the invention relate to integrated circuits with stacked memory modules.

### BACKGROUND OF THE INVENTION

Stacking semiconductor memory dies can increase memory capacity while keeping the same footprint. One of the well-known stacked memory technologies is high-bandwidth memory (HBM) technology. An HBM stack provides very wide channels for data, both within the stack and between the memory and logic dies. HBM has been adopted as a JEDEC (Joint Electron Device Engineering Council) standard. An HBM stack contains multiple dynamic random-access memory (DRAM) dies (e.g., four, eight, etc.) that are vertically stacked on top of a base die. High bandwidth between the DRAM dies is enabled by through-silicon vias (TSVs). The HBM stack resides on the same silicon interposer as a host processing die. The silicon interposer facilitates high-speed communication between the memory and host processors. Thus, HBM is well suited for handling increased memory requirements of graphic processing units (GPUs) and accelerator-based architectures such as artificial intelligence (AI) processors.

As industry continues to expand the applications of stacked memory devices, demand on bandwidth and capacity also continues to rise. Therefore, there is a need for further improving integrated circuit technologies that use stacked memory for high-capacity high bandwidth data storage.

### SUMMARY OF THE INVENTION

In one embodiment, an integrated circuit is provided. The integrated circuit includes a host die that is disposed on an interposer and includes processors. The integrated circuit further includes a base die disposed on the interposer. The base die includes at least two HBM stacks that are disposed on the base die and communicate with the host die through the base die and the interposer. The at least two HBM stacks and the host die are arranged in a row with the host die at one end of the row. The base die further includes a controller circuit operative to multiplex outgoing data from the at least two HBM stacks to the host die, and demultiplex incoming data from the host die to the at least two HBM stacks.

In another embodiment, a base die includes at least two HBM stacks that are disposed on the base die and communicate with a host die through the base die and an interposer. The base die further includes a controller circuit operative to multiplex outgoing data from the at least two HBM stacks to the host die, and demultiplex incoming data from the host die to the at least two HBM stacks. The at least two HBM stacks and the host die are arranged in a row with the host die at one end of the row.

In one embodiment, the at least two HBM stacks include a first HBM stack and a second HBM stack, and heat pipes are disposed in a vertical space on top of the base die between the first HBM stack and the second HBM stack.

In one embodiment, the controller circuit is further operative to multiplex the outgoing data from each HBM stack to the host die at a data rate that is twice the data rate of the HBM stack. In one embodiment, the controller circuit is further operative to interleave pseudo-channels of each HBM stack. In one embodiment, the controller circuit includes multiplexers and buffers operative to half a data width and double a data rate of the outgoing data from each HBM stack to the host die.

In one embodiment, the base die includes an error correction circuit coupled to each HBM stack and operative to perform error correction for the outgoing data from the HBM stack. In one embodiment, multiple base dies are disposed on top of the interposer and adjacent to the host die, and each base die includes the at least two HBM stacks.

In one embodiment, the base die includes a first physical layer interface circuit and the host die includes a second physical layer interface circuit, and both the first physical layer interface circuit and the second physical layer interface circuit operate according to a Universal Chiplet Interconnect Express (UCIe) protocol for data transfers between the base die and the host die. The base die may further include a UCIe controller coupled to an HBM controller for each HBM stack, and the HBM controller is further coupled to an HBM through-silicon vias (TSV) physical layer interface circuit for the HBM stack.

In one embodiment, the base die includes an enhanced HBM controller operative according to an HBM command set extended from a standard HBM comment set to include commands for controlling data multiplexing and de-multiplexing. The base die may include a first physical layer interface circuit and the host die may include a second physical layer interface circuit, and both the first physical layer interface circuit and the second physical layer interface circuit controlled by the enhanced HBM controller for data transfers between the base die and the host die.

Other aspects and features will become apparent to those ordinarily skilled in the art upon review of the following description of specific embodiments in conjunction with the accompanying figures.

### BRIEF DESCRIPTION OF DRAWINGS

The present invention is illustrated by way of example, and not by way of limitation, in the figures of the accompanying drawings in which like references indicate similar elements. It should be noted that different references to "an" or "one" embodiment in this disclosure are not necessarily to the same embodiment, and such references mean at least one. Further, when a particular feature, structure, or characteristic is described in connection with an embodiment, it is submitted that it is within the knowledge of one skilled in the art to effect such feature, structure, or characteristic in connection with other embodiments whether or not explicitly described.
FIG. 1 is a block diagram illustrating a side view of an integrated circuit (IC) package according to one embodiment.
FIG. 2 is a block diagram illustrating a heat pipe structure attached to the base die of FIG. 1 according to one embodiment.
FIG. 3A and FIG. 3B are diagrams illustrating HBM data transfers according to one embodiment.
FIG. 4 is a timing diagram illustrating multiplexing the data bits in two pseudo channels according to one embodiment.
FIG. 5 is a block diagram illustrating a top view of a multi-chip system according to some embodiments.
FIG. 6 is a block diagram illustrating a base die in communication with a host die according to one embodiment.
FIG. 7 is a diagram illustrating a base die in communication with a host die according to another embodiment.
FIG. 8 is a block diagram illustrating a top view of a portion of a wafer on which base dies are fabricated according to one embodiment.
FIG. 9 is a block diagram illustrating a base die including a compute unit according to one embodiment.
FIG. 10 is a diagram illustrating a base die including a compute unit according to an alternative embodiment.
FIG. 11 is a block diagram illustrating low-power double data rate (LPDDR) memory stacks coupled to a base die that includes a compute unit according to one embodiment.

### DETAILED DESCRIPTION OF THE INVENTION

In the following description, numerous specific details are set forth. However, it is understood that embodiments of the invention may be practiced without these specific details. In other instances, well-known circuits, structures, and techniques have not been shown in detail in order not to obscure the understanding of this description. It will be appreciated, however, by one skilled in the art, that the invention may be practiced without such specific details. Those of ordinary skill in the art, with the included descriptions, will be able to implement appropriate functionality without undue experimentation.

An integrated circuit (IC) system including multiple HBM stacks is described. In one embodiment, at least two HBM stacks are disposed on top of a base die. The base die, also referred to as a logic die, is fabricated using a semiconductor logic process, which creates ICs that performs logical operations on digital signals. The HBM stacks on the base die share the same physical layer (PHY) interface to communicate with a host die that includes host processors such as a central processing unit (CPU), a graphics processing unit (GPU), a digital signal processor (DSP), etc. When viewed from the top, the HBM stacks and the host die form a row, with the host die at one end of the row. This arrangement of the HBM stacks increases memory capacity without increasing the shoreline, i.e., the boundary between the base die and the host die. In one embodiment, the base die may include a controller that multiplexes outgoing data from the HBM stacks to the host die at a higher data rate than the data rate of each HBM stack to increase the memory bandwidth. In one embodiment, a high-speed die-to-die PHY interface may be used for the data transfer between the base die and the host die.

As used herein, the term "die" refers to a semiconductor integrated circuit on which memory cells and/or logic circuit elements are created. The term "bandwidth" or "memory bandwidth" refers to the rate at which data is transferred between a host die and a base die. In the following description, a base die having two HBM stacks thereon are shown and described. It is understood that the method and system described herein are applicable to more than two HBM stacks disposed on a base die, where the more than two HBM stacks and the host die form a row with the host die at one end of the row.

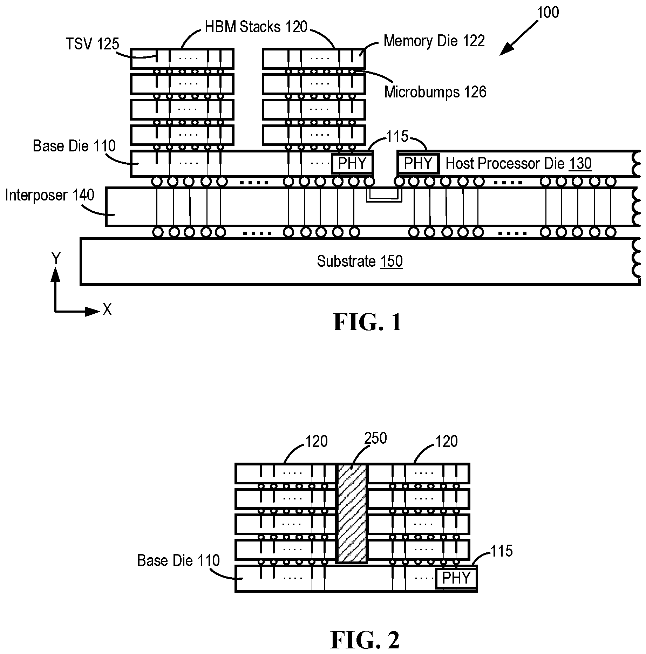

FIG. 1 is a block diagram illustrating a side view of an IC package 100 according to one embodiment. The IC package 100 includes a host die 130 and a base die 110 on an interposer 140 and a substrate 150. On top of the base die 110 are two HBM stacks 120 aligned in a direction perpendicular to the shoreline of the host die 130. More specifically, the two HBM stacks 120 and the host die 130 are arranged in a row with the host die 130 at one end of the row. The base die 110 includes controller circuitry to manage the communication with the host die 130, data transfer from and to the HBM stacks 120, command decoding, and other functions. The host die 130 may include one or more CPUs, GPUs, neural processing units (NPUs), DSPs, etc.

Each HBM stack 120 includes multiple memory dies 122 such as DRAM dies that are connected vertically to the base die 110 by through-silicon vias (TSVs) 125 and microbumps 126. The HBM stacks 120 are connected to the host die 130 by metal traces in the interposer 140. The base die 110 and the host die 130 each include a PHY interface 115, which is an interface circuit that handles the physical transmission of data.

As a non-limiting example, each HBM stack 120 may include four vertically-stacked memory dies 122, although a different number of memory dies 122 may be stacked to form an HBM stack. Compared to one HBM stack formed by eight memory dies 122, the two HBM stacks 120 each formed by four memory dies 122 allows better heat dissipation. In one embodiment, heat pipes may be added to the IC package 100 as shown in the embodiment of FIG. 2.

FIG. 2 is a block diagram illustrating a heat pipe structure 250 attached to the base die 110 of FIG. 1 according to one embodiment. In one embodiment, the space between the two HBM stacks 120 on top of the base die 110 can be utilized for the heat pipe structure 250 to transfer heat out of the base die 110. In one embodiment, the heat pipe structure 250 may be attached to a heat spreader and bonded to the top on the base die 110 using a thermal interface material. The space between the two HBM stacks 120 may also be used for other electrical connections such as power and/or ground distribution lines.

Referring to FIG. 1 and FIG. 2, in one embodiment, the PHY interface 115 in the base die 110 and the host die 130 may be an HBM PHY. The HBM PHY is standardized by JEDEC for connecting host processors to HBM stacks. The HBM PHY has low latency, low power consumption, and follows a simple protocol for memory read and write. In an alternative embodiment, the PHY interface 115 may be a Universal Chiplet Interconnect Express (UCIe) PHY, which is standardized for die-to-die communication within a system-in-package (SiP). The UCIe PHY supports memory, computation, and networking traffic, and can operate at a higher data rate than the HBM PHY. The UCIe PHY follows a multilayered protocol and, therefore, has a slightly higher power consumption and latency than the HBM PHY. The data width of the UCIe PHY can be configurable.

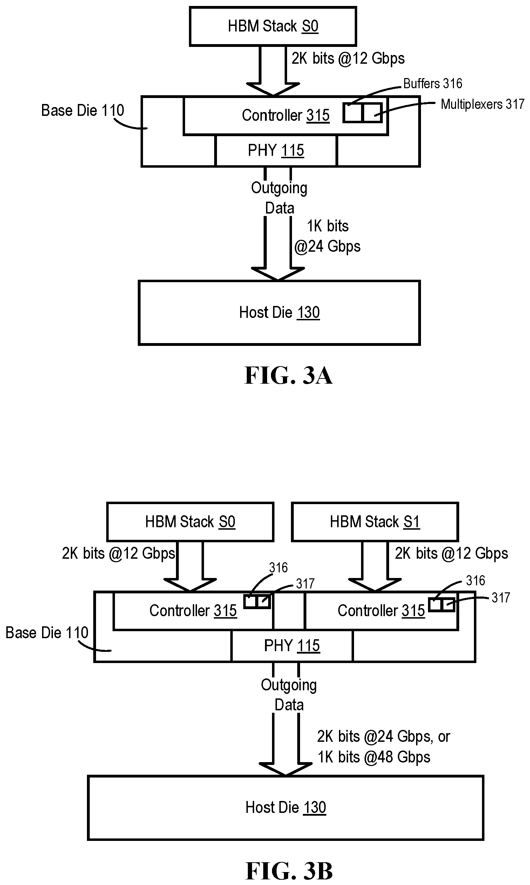

FIG. 3A and FIG. 3B are diagrams illustrating HBM data transfers according to one embodiment. Although specific data widths and data rates are shown and described, it is understood that the numbers used in the examples are non-limiting. FIG. 3A shows the base die 110 transmitting data from an HBM stack S0 (which can be either one of the HBM stacks 120 in FIG. 1) to the host die 130. The PHY interface 115 may support a data rate that is twice as fast as the data rate of the HBM stack S0. In one embodiment, the PHY interface 115 may support half the data width and double the data rate of the outgoing data from the HBM stack S0 to the host die 130. For example, the HBM stack S0 may sustain a data rate of 12 gigabits per second (Gbps) at 2K bits data width, and the PHY interface 115 may support 24 Gbps data rate. In one embodiment, the base die 110 includes a controller circuit 315 that includes buffers 316 and multiplexers 317 to output data of 1K bits data width to the host die 130 at a data rate of 24 Gbps.

FIG. 3B shows the base die 110 transmitting data from both HBM stacks S0 and S1 (which are the two HBM stacks 120 in FIG. 1) to the host die 130. In this example, each of the HBM stacks S0 and S1 sustains a data rate of 12 Gbps at 2K bits data width, and the PHY interface 115 supports 48 Gbps data rate. In one embodiment, the base die 110 includes the controller circuit 315 for each HBM stack. The controller circuits 315 include buffers 316 and multiplexers 317 to output data to the host die 130, where the data may have 2K bits data width at a data rate of 24 Gbps, or 1K bits data width at a data rate of 48 Gbps. That is, the outgoing data from the base die 110 with N HBM stacks 120 to the host die 130 may have the same data width and N times the data rate of a single HBM stack 120 (N being a positive integer). Alternatively, the outgoing data from the base die 110 with N HBM stacks 120 to the host die 130 may have the (1/K) times the data width and (K×N) times the data rate of a single HBM stack 120 (N and K being positive integers).

The use of two memory stacks on the logic die not only doubles memory capacity but can also increase memory bandwidth. The examples of FIG. 3A and FIG. 3B show that the data rate at the base die's output to the host may double or quadruple the data rate of an individual HBM stack. To achieve the increased data rates, the controller circuit 315 may include one or more multiplexers 317 and buffers 316 to interleave the outgoing data from the HBM stacks, e.g., by interleaving the outgoing data bits in each pair of pseudo-channels of each HBM stack at 2 times or 4 times the data rate of the HBM stack. In alternative embodiments, the interleaving may be performed on more than two pseudo-channels across multiple channels of an HBM stack or both HBM stacks. In one embodiment, a group of bits (e.g., a byte, a word, etc.) across two or more pseudo-channels may be interleaved at a higher data rate than the data rate of each HBM stack. In the example of FIG. 3B, the base die's outgoing data may maintain the same data width and double the data rate of each HBM stack. In another embodiment, the base die's outgoing data may half the data width and quadruple the data rate of each HBM stack.

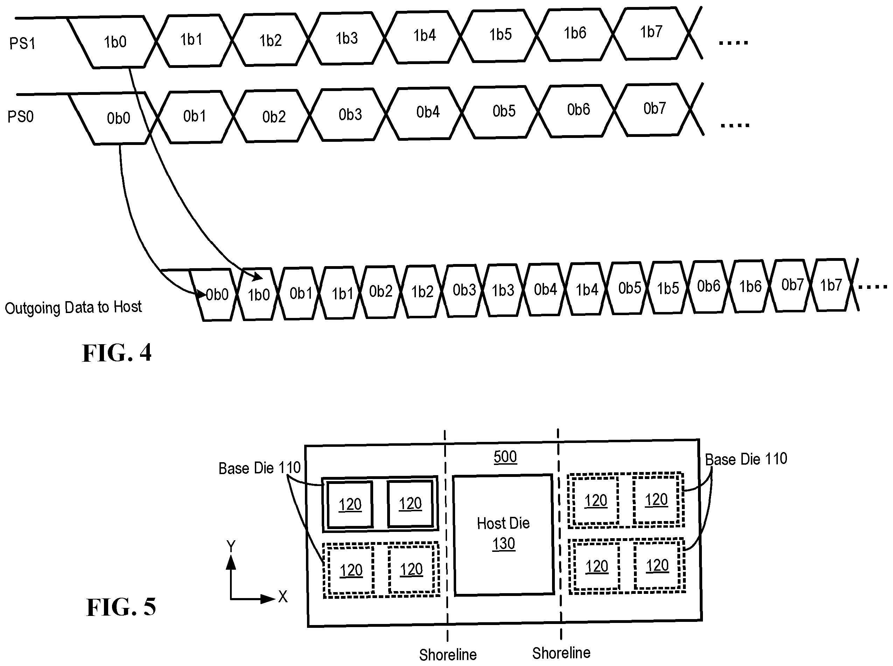

FIG. 4 is a timing diagram illustrating multiplexing the data bits in two pseudo channels according to one embodiment. In one embodiment, each HBM stack (S0, S1) contains eight independent channels and each channel has its own clock, commands, address and data interface, and can operate independently of other channels. Each channel can be divided into two pseudo channels (e.g., PC0 and PC1). In this example, the data from PC0 and PC1 are interleaved bit-by-bit and time-multiplexed into one outgoing data stream at twice the data rate of each individual pseudo channel. As described with reference to FIG. 3A and FIG. 3B, the interleaving may be performed on a data unit greater than one bit, and the outgoing data rate may be different than twice the data rate of each individual pseudo channel.

FIG. 5 is a block diagram illustrating a top view of a multi-chip system 500 according to some embodiments. The system 500 may be a system-in-package (SiP). In one embodiment, the system 500 includes one or more pairs of HBM stacks 120, with each pair disposed on a corresponding base die 110. All of the base dies 110 are connected to the host die 130 via metal traces in the interposer 140 (FIG. 1). The system 500 may include one pair of HBM stacks 120 on the base die 110 (as shown in the side view of FIG. 1), or more than one pair of HBM stacks 120 (as shown in FIG. 5 in dotted lines). Two HBM stacks 120 placed along the X-direction occupies half the shoreline length compared to two HBM stacks 120 placed along the Y-direction, with the same memory capacity. This example shows that the freed-up shoreline can be used for more HBM stacks 120. Alternatively, the freed-up shoreline can be used for additional circuitry in the system 500.

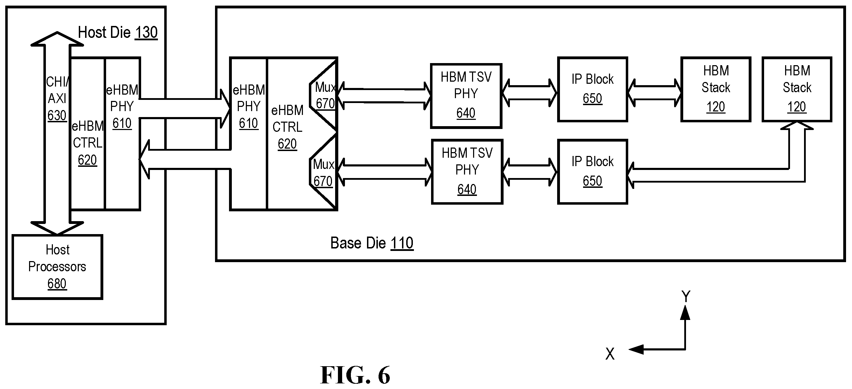

FIG. 6 is a block diagram illustrating the base die 110 in communication with the host die 130 according to one embodiment. It is understood that the HBM stacks 120 are on top of the base die 110 and aligned along the X-direction, as shown in the embodiment of FIG. 1. In one embodiment, the base die 110 and the host die 130 communicate with each other using an enhanced HBM PHY interface circuit ("eHBM PHY 610"). The eHBM PHY 610 supports the increased data rates shown in the non-limiting examples of FIG. 3A and FIG. 3B. Operations of the eHBM PHY 610 may be controlled by an eHBM controller 620, which is an example of the controller 315 in FIG. 3A and FIG. 3B. Both the eHBM PHY 610 and the eHBM controller 620 support an extended command set for enhanced HBM functions. In one embodiment, the extended command set may include the standard HBM commands, command extensions (e.g., for controlling data multiplexing/de-multiplexing, etc.), and customized commands. In one embodiment, the eHBM controller 620 on the base die 110 includes two or more multiplexers 670 to multiplex outgoing data from two or more pseudo-channels of each HBM stack 120 into a data stream, and to de-multiplex incoming data from the host die 130 into the corresponding pseudo-channels according to the memory addresses indicated in the host commands.

In one embodiment, the eHBM controller 620 on the base die 110 is coupled to two HBM TSV PHY circuits 640, one for each HBM stack 120. The HBM TSV PHY circuit 640 handles the electrical signaling and data transfer between the base die 110 and the corresponding HBM stack 120. In one embodiment, each HBM TSV PHY circuit 640 may be coupled to an intellectual property (IP) block 650 provided by the HBM vendor, e.g., advanced error-correction code functional unit. Each IP block 650 is coupled to a corresponding HBM stack 120. In alternative embodiment without the IP blocks 650, each HBM TSV PHY circuit 640 may be directly coupled to the corresponding HBM stack 120.

In the embodiment of FIG. 6, the host die 130 also includes the eHBM PHY 610 and the eHBM controller 620 to communicate with the base die 110. The eHBM controller 620 on the host die may communicate with host processors 680 via an on-die data connection that follows a protocol such as AXI (Advanced eXtensible Interface) or CHI (Coherent Hub Interface), indicated in FIG. 6 as AXI/CHI 630.

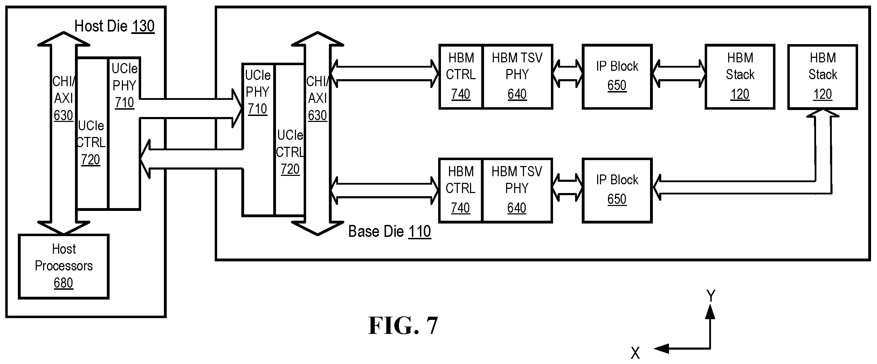

FIG. 7 is a block diagram illustrating the base die 110 in communication with the host die 130 according to another embodiment. It is understood that the HBM stacks 120 are on top of the base die 110 and aligned along the X-direction, as shown in the embodiment of FIG. 1. In one embodiment, data transfer between the base die 110 and the host die 130 may use a high data rate die-to-die interface such as the UCIe PHY 710. Operations of the UCIe PHY 710 is controlled by a UCIe controller 720. The UCIe controller 720 communicates with two HBM controllers 740, one for each HBM stack 120 via the on-die data connection AXI/CHI 630. Each HBM controller 740 is coupled to the corresponding HBM TSV PHY circuit 640. In one embodiment, each HBM TSV PHY circuit 640 may be coupled to the IP block 650 mentioned before with reference to FIG. 6, and each IP block 650 is coupled to a corresponding HBM stack 120. In alternative embodiment without the IP blocks 650, each HBM TSV PHY circuit 640 may be directly coupled to the corresponding HBM stack 120.

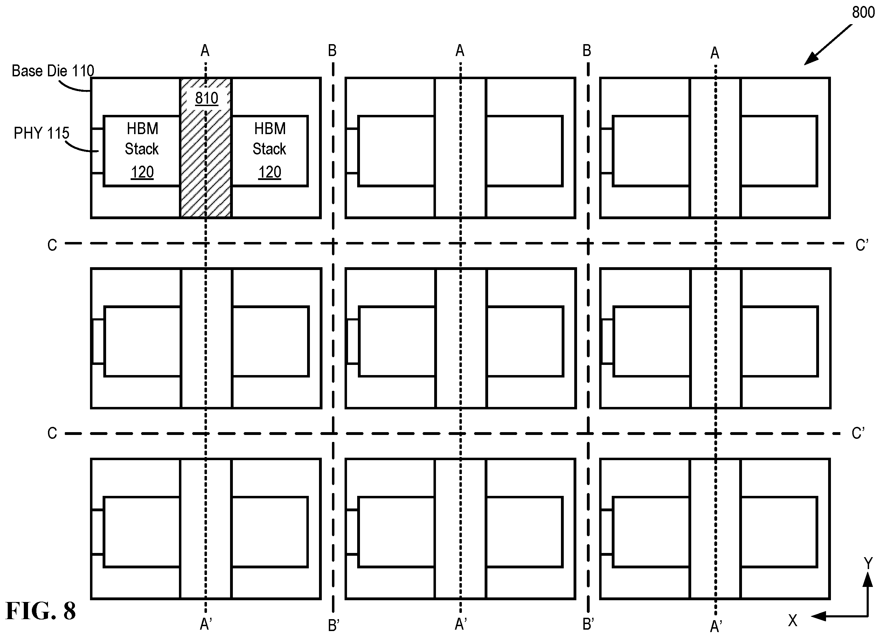

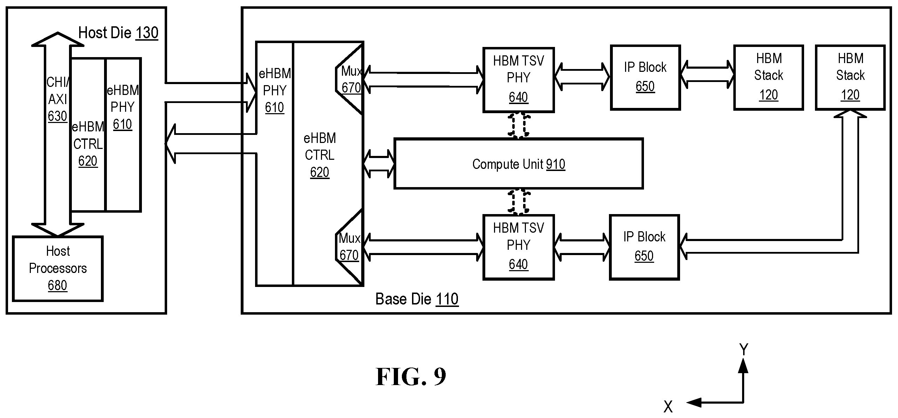

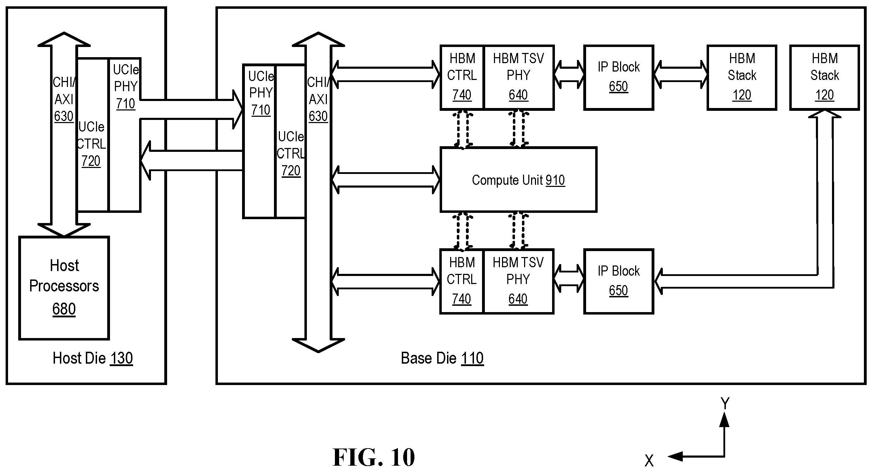

FIG. 8 is a block diagram illustrating a top view of a portion of a wafer 800 on which a plurality of the base dies 110 are fabricated according to one embodiment. Only one base die 110 on the upper left corner of the diagram is labeled to avoid cluttering the diagram. Each base die 110 includes two HBM stacks 120 thereon. Each base die 110 further includes logic circuitry such as the PHY interface 115 and other circuitry therewithin. It is understood that the blocks representing the base die 110 and the PHY interface 115 in FIG. 8 are merely illustrative, e.g., the PHY interface 115 maybe hidden under the base die 110, and the exposed area of the base die 110 from underneath the HBM stacks 120 (in the top view) may be much smaller (relative to the total size of the base size 110) than what is shown. On the wafer 800, the base dies 110 are arranged in rows and columns. To create a base die having a single HBM stack 120 thereon, the wafer 800 would be cut along the cut lines A-A', B-B', and C-C'. To create a base die having two HBM stacks 120 according to the embodiment of FIG. 1, the wafer 800 is cut along the cut lines B-B' and C-C', leaving the base die area 810 marked by slanted lines intact. The base die area 810 can be used to accommodate logic circuitry such as compute near memory (CNM) circuitry, as shown in the examples of FIG. 9 and FIG. 10.

FIG. 9 is a block diagram illustrating the base die 110 including a compute unit 910 (also referred to as compute circuitry) according to one embodiment. The host die 130 and the base die 110 in this embodiment includes all of the same elements as those in the embodiment of FIG. 6, and the base die 110 additionally includes a compute unit 910. The HBM stacks 120 are on top of the base die 110 and aligned along the X-direction, as shown in the embodiment of FIG. 1. The two HBM stacks 120 and the host die 130 are arranged in a row with the host die 130 at one end of the row.

In one embodiment, the compute unit 910 may be a customized IP block implemented by application-specific integrated circuits (ASICs), field-programmable gate arrays (FPGAs), etc. In one embodiment, at least a portion of the compute unit 910 may be disposed in the base die 110 between the two HBM stacks 120, such as in the area 810 of FIG. 8. Being on the same base die 110 as the HBM stacks 120, the compute unit 910 can access both HBM stacks 120 with low latency. With the compute unit 910 on the base die 110, the overall computation efficiency improves not only from low-latency HBM access for the compute unit 910, but also from lower power consumption due to the reduction in unnecessary bit traffic between the base die 110 and the host die 130. The compute unit 910 may access any of the pseudo-channels in the HBM stacks 120. The two HBM stacks 120 double the memory capacity of a single HBM stack and, therefore, double the amount of data that the compute unit 910 can efficiently operate on.

With respect to the reduction in unnecessary data movement between the HBM and the host die 130, the compute unit 910 can efficiently perform read-operate-writeback, by reading data from the HBM stacks 120, executing instructions received from the host die 130, and writing back results of the execution to the host die 130. For example, the operation OP(A,B) → C may be performed by the compute unit 910 instead of by the host processors 680 to reduce data movement. The compute unit 910 may access any of the two HBM stacks 120 to retrieve A and B, perform OP(A,B), and transport C back to the host die 130 to save bandwidth and power. In one embodiment, the compute unit 910 may speculatively perform OP(A, B) → C and stores C back to a local memory on the base die 110 (e.g., one of the HBM stacks 120, a cache, etc.). The result C can be retrieved and sent to the host die 130 just in time when the host processors 680 need it. The result C can be discarded if the host processors 680 do not need it.

For a streaming workload, the compute unit 910 may execute a for-loop of OP(A[x], B[x]) → C[x] for x = 1 to N. It is understood that the one-dimensional for-loop is a non-limiting example; the description herein applies to multi-dimensional for-loops. The input operands A[x], B[x] may be distributed across multiple banks of the two HBM stacks 120 and accessed via corresponding channels of the HBM stacks 120. The results C[x] can be streamed back to the host die 130 when one or more of the host processors 680 need the results, and can be discarded at the base die 110 if none of the host processors 680 need them. Furthermore, if one or more of the host processors 680 only need a subset of C[x], the compute unit 910 may receive one or more commands from the host die 130 requesting the subset of C[x] to be computed. In response to the command(s), the compute unit 910 performs the corresponding operations to compute only the subset of C[x] and sends the subset to the host die 130, thereby saving power and improving system efficiency. If the compute unit 910 has already speculatively calculated additional C[x]'s not needed by the host processors 680, these additional C[x]'s may be discarded at the base die 110. Discarding the result of speculative operation incurs minimal power penalty and has no impact on the bandwidth between the base die 110 and the host die 130. Speculative operations as described herein can hide processing latency. Discarding the result of a speculative operation incurs minimal power penalty and does not negatively impact the bandwidth between the base die 110 and the host die 130. In one embodiment, the compute unit 910 may perform additional speculative computations to further improve performance, e.g., branch prediction, speculative fetch, etc.

In one embodiment, the compute unit 910 may include multiple processing elements (e.g., multipliers, adders, etc.) that can operate in parallel. Parallel computations on large data sets are often required by AI processing, multimedia processing, scientific computations, etc. For example, the compute unit 910 may perform matrix multiplications, multiply-and-accumulate, convolutions, activation functions (e.g., Sigmoid, ReLU, Tanh, Softmax, etc.), computations of key-value store, etc., all of which are often performed in AI computations. The compute unit 910 may also perform data-intensive computations such as data compression/decompression, encryption, etc.

In one embodiment, the compute unit 910 may access data in the HBM stacks 120 via on-die communication paths through the eHBM controller 620. In an alternative embodiment, the compute unit 910 may directly communicate with the HBM TSV PHY 640 to access data in the HBM stacks 120. The eHBM controller 620 may send outgoing data from the two HBM stacks 120 and the compute circuitry 910 at a higher data rate than the data rate supported by each HBM stack 120.

FIG. 10 is a block diagram illustrating the base die 110 including the compute unit 910 according to another embodiment. The host die 130 and the base die 110 in this embodiment includes all of the same elements as those in the embodiment of FIG. 7, and the base die 110 additionally includes the compute unit 910 described with reference to FIG. 9. In this embodiment, the UCIe PHY 710 and the UCIe controller 720 are used for the communication between the base die 110 and the host die 130. With the inclusion of the compute unit 910 and other additional circuitry (e.g., the IP blocks 650) on the base die 110, the UCIe interface can provide the needed bandwidth and data rate between the base die 110 and the host die 130.

In one embodiment, the compute unit 910 may access data in the HBM stacks 120 via on-die connection such as the AXI/CHI 630. In an alternative embodiment, the compute unit 910 may directly communicate with the HBM controller 740 or the HBM TSV PHY 640 to access data in the HBM stacks 120.

Referring to the embodiments in FIG. 8 and FIG. 9, the compute unit 910 may receive commands from the host processors 680 to perform operations. In one embodiment, the extended command set may include the standard HBM commands, command extensions (e.g., for controlling data multiplexing/de-multiplexing, etc.), commands directed to the compute unit 910, and customized commands. In one embodiment, a power gate may be added to the compute unit 910 when the compute unit 910 is not actively in use or when there is a need to reduce power consumption.

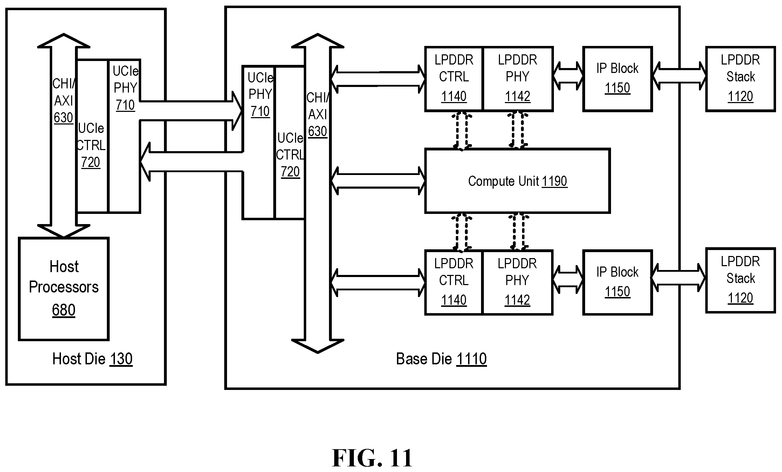

It is noted that stacked memory technologies are not limited to the HBM described above. In one embodiment, low-power double data rate (LPDDR) stacks may provide the needed high-capacity and high-bandwidth with a lower cost than the HBM stacks 120. FIG. 11 is a block diagram illustrating LPDDR stacks coupled to a base die 1110 that includes a compute unit 1190 according to one embodiment. The near-memory computing techniques described in connection with HBM stacks 120 can be applied to memory stacks formed by other memory technologies, such as LPDDR memory modules. For example, an LPDDR stack 1120 may be formed by vertically wire-bonding multiple LPDDR dies, one on top of another, with the bottom LPDDR die wire-bonded to a package substrate. Alternatively, each LPDDR stack 1120 may be encapsulated in a package. The base die 1110 includes an LPDDR PHY circuit 1142 for each LPDDR stack 1120 to handle the electrical signaling and data transfer between the base die 1110 and the corresponding LPDDR stack 1120. The LPDDR PHY circuit 1142 may be coupled to an IP block 1150 provided by the LPDDR vendor, such as advanced error-correction code functional units. The base die 1110 also includes an LPDDR controller 1140 for each LPDDR stack 1120 to control the operations of the LPDDR PHY circuit 1142. In one embodiment, the LPDDR controller 1140 may include multiplexers and buffers to multiplex data across multiple banks of the corresponding LPDDR stack 1120 to increase the data rate of the outgoing data to the host die 130. The LPDDR controller 1140 may send outgoing data from the two LPDDR stacks 1120 and the compute circuitry 1190 at a higher data rate than the data rate supported by each LPDDR stack 1120.

In one embodiment, data transfer between the base die 1110 and the host die 130 may use a high data rate die-to-die physical layer interface such as the UCIe PHY 710. Operations of the UCIe PHY 710 is controlled by a UCIe controller 720. The UCIe controller 720 communicates with the two LPDDR controllers 1140 via an on-die data connection (e.g., AXI/CHI 630).

In one embodiment, the base die 1110 may include a compute unit 1190 that performs the same data-intensive and/or speculative near-memory computations as the compute unit 910 of FIG. 9 and FIG. 10. The compute unit 1190 includes multipliers and adders to perform operations in parallel, such as those required by AI computations. Like the compute unit 910 of FIG. 9 and FIG. 10, the compute unit 1190 can efficiently perform read-operate-writeback, by reading data from the LPDDR stacks 1120, executing instructions received from the host die 130, and writing back results of the execution to the host die 130.

In one embodiment, the compute unit 1190 is operative to access data from the LPDDR stacks 1120 via the on-die data connection AXI/CHI 630, the LPDDR controller 1140, and/or the LPDDR PHY circuit 1420. The compute unit 1190 may receive commands from the host processors 680 to perform operations. In one embodiment, the extended command set may include the standard LPDDR commands, command extensions (e.g., for controlling data multiplexing/de-multiplexing, etc.), commands directed to the compute unit 1190, and customized commands. In one embodiment, a power gate may be added to the compute unit 1190 when the compute unit 1190 is not actively in use or when there is a need to reduce power consumption.

Various functional components or blocks have been described herein. As will be appreciated by persons skilled in the art, the functional blocks will preferably be implemented through circuits (either dedicated circuits or general-purpose circuits, which operate under the control of one or more processors and coded instructions), which will typically comprise transistors that are configured in such a way as to control the operation of the circuitry in accordance with the functions and operations described herein.

While the invention has been described in terms of several embodiments, those skilled in the art will recognize that the invention is not limited to the embodiments described, and can be practiced with modification and alteration within the spirit and scope of the appended claims. The description is thus to be regarded as illustrative instead of limiting.

The present invention may also be defined by the following numbered clauses.
Clause 1. An integrated circuit, comprising: a host die disposed on an interposer and including a plurality of processors; and a base die disposed on the interposer and including at least two high-bandwidth memory (HBM) stacks that are disposed on the base die and communicate with the host die through the base die and the interposer, wherein the at least two HBM stacks and the host die are arranged in a row with the host die at one end of the row, and wherein the base die further includes a controller circuit operative to multiplex outgoing data from the at least two HBM stacks to the host die, and demultiplex incoming data from the host die to the at least two HBM stacks.
Clause 2. The integrated circuit of clause 1, wherein the at least two HBM stacks include a first HBM stack and a second HBM stack, the integrated circuit further comprises: heat pipes disposed in a vertical space on top of the base die between the first HBM stack and the second HBM stack.
Clause 3. The integrated circuit of clause 1, wherein the controller circuit is further operative to multiplex the outgoing data from each HBM stack to the host die at a data rate that is twice the data rate of the HBM stack.
Clause 4. The integrated circuit of clause 1, wherein the controller circuit is further operative to interleave pseudo-channels of each HBM stack.
Clause 5. The integrated circuit of clause 1, wherein the controller circuit includes multiplexers and buffers operative to half a data width and double a data rate of the outgoing data from each HBM stack to the host die.
Clause 6. The integrated circuit of clause 1, wherein the base die includes an error correction circuit coupled to each HBM stack and operative to perform error correction for the outgoing data from the HBM stack.
Clause 7. The integrated circuit of clause 1, wherein the base die includes a first physical layer interface circuit and the host die includes a second physical layer interface circuit, and both the first physical layer interface circuit and the second physical layer interface circuit operate according to a Universal Chiplet Interconnect Express (UCIe) protocol for data transfers between the base die and the host die.
Clause 8. The integrated circuit of clause 7, wherein the base die further includes a UCIe controller coupled to an HBM controller for each HBM stack, and the HBM controller is further coupled to an HBM through-silicon vias (TSV) physical layer interface circuit for the HBM stack.
Clause 9. The integrated circuit of clause 1, wherein the base die includes an enhanced HBM controller operative according to an HBM command set extended from a standard HBM comment set to include commands for controlling data multiplexing and de-multiplexing.
Clause 10. The integrated circuit of clause 9, wherein the base die includes a first physical layer interface circuit and the host die includes a second physical layer interface circuit, and both the first physical layer interface circuit and the second physical layer interface circuit controlled by the enhanced HBM controller for data transfers between the base die and the host die.
Clause 11. The integrated circuit of clause 1, wherein a plurality of base dies are disposed on top of the interposer and adjacent to the host die, each base die includes the at least two HBM stacks.
Clause 12. A base die, comprising: at least two high-bandwidth memory (HBM) stacks that are disposed on the base die and communicate with a host die through the base die and an interposer; and a controller circuit operative to multiplex outgoing data from the at least two HBM stacks to the host die, and demultiplex incoming data from the host die to the at least two HBM stacks, wherein the at least two HBM stacks and the host die are arranged in a row with the host die at one end of the row.
Clause 13. The base die of clause 12, wherein the at least two HBM stacks include a first HBM stack and a second HBM stack, the integrated circuit further comprises: heat pipes disposed in a vertical space on top of the base die between the first HBM stack and the second HBM stack.
Clause 14. The base die of clause 12, wherein the controller circuit is further operative to multiplex the outgoing data from each HBM stack to the host die at a data rate that is twice the data rate of the HBM stack.
Clause 15. The base die of clause 12, wherein the controller circuit is further operative to interleave pseudo-channels of each HBM stack.
Clause 16. The base die of clause 12, wherein the controller circuit includes multiplexers and buffers operative to half a data width and double a data rate of the outgoing data from each HBM stack to the host die.
Clause 17. The base die of clause 12, wherein the base die includes an error correction circuit coupled to each HBM stack and operative to perform error correction for the outgoing data from the HBM stack.
Clause 18. The base die of clause 12, wherein the base die includes a first physical layer interface circuit and the host die includes a second physical layer interface circuit, and both the first physical layer interface circuit and the second physical layer interface circuit operate according to a Universal Chiplet Interconnect Express (UCIe) protocol for data transfers between the base die and the host die.
Clause 19. The base die of clause 18, wherein the base die further includes a UCIe controller coupled to an HBM controller for each HBM stack, and the HBM controller is further coupled to an HBM through-silicon vias (TSV) physical layer interface circuit for the HBM stack.
Clause 20. The base die of clause 12, wherein the base die includes a first physical layer interface circuit and the host die includes a second physical layer interface circuit, and both the first physical layer interface circuit and the second physical layer interface circuit controlled by an enhanced HBM controller for data transfers between the base die and the host die, and wherein the enhanced HBM controller is operative according to a command set extended from a standard HBM comment set to include commands for controlling data multiplexing and de-multiplexing.

## Claims

1. An integrated circuit, comprising:
a host die (130) disposed on an interposer (140) and including a plurality of processors; and
a base die (110, 1110) disposed on the interposer (140) and including at least two high-bandwidth memory, HBM, stacks (120) that are disposed on the base die (110, 1110) and communicate with the host die (130) through the base die (110, 1110) and the interposer (140),
wherein the at least two HBM stacks (120) and the host die (130) are arranged in a row with the host die (130) at one end of the row, and
wherein the base die (110, 1110) further includes a controller circuit (315) operative to multiplex outgoing data from the at least two HBM stacks (120) to the host die (130), and demultiplex incoming data from the host die (130) to the at least two HBM stacks (120).

2. The integrated circuit of claim 1, wherein the at least two HBM stacks (120) include a first HBM stack (120) and a second HBM stack (120), the integrated circuit further comprises:
heat pipes disposed in a vertical space on top of the base die (110, 1110) between the first HBM stack (120) and the second HBM stack (120).

3. The integrated circuit of claim 1, wherein the controller circuit (315) is further operative to multiplex the outgoing data from each HBM stack (120) to the host die (130) at a data rate that is twice the data rate of the HBM stack (120).

4. The integrated circuit of claim 1, wherein the controller circuit (315) is further operative to interleave pseudo-channels of each HBM stack (120).

5. The integrated circuit of claim 1, wherein the controller circuit (315) includes multiplexers (317) and buffers (316) operative to half a data width and double a data rate of the outgoing data from each HBM stack (120) to the host die (130); or
wherein the base die (110, 1110) includes an error correction circuit coupled to each HBM stack (120) and operative to perform error correction for the outgoing data from the HBM stack (120).

6. The integrated circuit of claim 1, wherein the base die (110, 1110) includes a first physical layer interface circuit and the host die (130) includes a second physical layer interface circuit, and both the first physical layer interface circuit and the second physical layer interface circuit operate according to a Universal Chiplet Interconnect Express, UCIe, protocol for data transfers between the base die (110, 1110) and the host die (130);
optionally wherein the base die (110, 1110) further includes a UCIe controller (720) coupled to an HBM controller (740) for each HBM stack (120), and the HBM controller (740) is further coupled to an HBM through-silicon vias, TSV, physical layer interface circuit for the HBM stack (120).

7. The integrated circuit of claim 1, wherein the base die (110, 1110) includes an enhanced HBM controller (740) operative according to an HBM command set extended from a standard HBM comment set to include commands for controlling data multiplexing and de-multiplexing;
optionally wherein the base die (110, 1110) includes a first physical layer interface circuit and the host die (130) includes a second physical layer interface circuit, and both the first physical layer interface circuit and the second physical layer interface circuit controlled by the enhanced HBM controller (740) for data transfers between the base die (110, 1110) and the host die (130).

8. The integrated circuit of claim 1, wherein a plurality of base dies (110, 1110) are disposed on top of the interposer (140) and adjacent to the host die (130), each base die (110, 1110) includes the at least two HBM stacks (120).

9. A base die (110, 1110), comprising:
at least two high-bandwidth memory, HBM, stacks (120) that are disposed on the base die (110, 1110) and communicate with a host die (130) through the base die (110, 1110) and an interposer (140); and
a controller circuit (315) operative to multiplex outgoing data from the at least two HBM stacks (120) to the host die (130), and demultiplex incoming data from the host die (130) to the at least two HBM stacks (120),
wherein the at least two HBM stacks (120) and the host die (130) are arranged in a row with the host die (130) at one end of the row.

10. The base die (110, 1110) of claim 9, wherein the at least two HBM stacks (120) include a first HBM stack (120) and a second HBM stack (120), the integrated circuit further comprises:
heat pipes disposed in a vertical space on top of the base die (110, 1110) between the first HBM stack (120) and the second HBM stack (120).

11. The base die (110, 1110) of claim 9, wherein the controller circuit (315) is further operative to multiplex the outgoing data from each HBM stack (120) to the host die (130) at a data rate that is twice the data rate of the HBM stack (120).

12. The base die (110, 1110) of claim 9, wherein the controller circuit (315) is further operative to interleave pseudo-channels of each HBM stack (120).

13. The base die (110, 1110) of claim 9, wherein the controller circuit (315) includes multiplexers (317) and buffers (316) operative to half a data width and double a data rate of the outgoing data from each HBM stack (120) to the host die (130); or
wherein the base die (110, 1110) includes an error correction circuit coupled to each HBM stack (120) and operative to perform error correction for the outgoing data from the HBM stack (120).

14. The base die (110, 1110) of claim 9, wherein the base die (110, 1110) includes a first physical layer interface circuit and the host die (130) includes a second physical layer interface circuit, and both the first physical layer interface circuit and the second physical layer interface circuit operate according to a Universal Chiplet Interconnect Express, UCIe, protocol for data transfers between the base die (110, 1110) and the host die (130);
optionally wherein the base die (110, 1110) further includes a UCIe controller (720) coupled to an HBM controller (740) for each HBM stack (120), and the HBM controller (740) is further coupled to an HBM through-silicon vias, TSV, physical layer interface circuit for the HBM stack (120).

15. The base die (110, 1110) of claim 9, wherein the base die (110, 1110) includes a first physical layer interface circuit and the host die (130) includes a second physical layer interface circuit, and both the first physical layer interface circuit and the second physical layer interface circuit controlled by an enhanced HBM controller (620) for data transfers between the base die (110, 1110) and the host die (130), and wherein the enhanced HBM controller (620) is operative according to a command set extended from a standard HBM comment set to include commands for controlling data multiplexing and de-multiplexing.
